(19) Europäisches Patentamt
European Patent Office
Office européen des brevets

(11) **EP 4 198 985 A1**

(12) **DEMANDE DE BREVET EUROPEEN**

(43) Date de publication:
**21.06.2023 Bulletin 2023/25**

(21) Numéro de dépôt: **22212693.0**

(22) Date de dépôt: **12.12.2022**

(51) Classification Internationale des Brevets (IPC):
**G11C 13/00** (2006.01)　　**G11C 11/16** (2006.01)
**G11C 5/14** (2006.01)　　**H10B 63/00** (2023.01)

(52) Classification Coopérative des Brevets (CPC):
**G11C 13/0069; G11C 5/147; G11C 11/1659;
G11C 11/1675; G11C 11/1693; G11C 11/1697;
G11C 13/0004; G11C 13/003; G11C 13/0038;
G11C 13/0061;** G11C 2213/76; H10B 63/24;
H10B 63/80

(84) Etats contractants désignés:
**AL AT BE BG CH CY CZ DE DK EE ES FI FR GB
GR HR HU IE IS IT LI LT LU LV MC ME MK MT NL
NO PL PT RO RS SE SI SK SM TR**
Etats d'extension désignés:
**BA**
Etats de validation désignés:
**KH MA MD TN**

(30) Priorité: **14.12.2021　FR 2113463**

(71) Demandeurs:
• **Commissariat à l'énergie atomique
et aux énergies alternatives
75015 Paris (FR)**
• **Weebit Nano Ltd
4527713 Hod-HaSharon (IL)**

(72) Inventeurs:
• **TROTTI, Paola
38054 GRENOBLE CEDEX 09 (FR)**
• **MOLAS, Gabriel
38054 GRENOBLE CEDEX 09 (FR)**
• **PILLONNET, Gaël
38054 GRENOBLE CEDEX 09 (FR)**
• **VERDY, Anthonin
38040 GRENOBLE CEDEX 09 (FR)**
• **REGEV, Amir
71708 MODIIN (IL)**

(74) Mandataire: **Cabinet Camus Lebkiri
25 rue de Maubeuge
75009 Paris (FR)**

(54) **MÉMOIRE RÉSISTIVE À SÉLECTEUR, ÉQUIPÉE D'UN CONDENSATEUR D'ÉCRITURE, ET PROCÉDÉ D'ÉCRITURE ASSOCIÉ**

(57) Une telle mémoire (1), comprenant au moins une cellule (20) mémoire résistive et un dispositif d'écriture (3a). La cellule mémoire (20) comprend un élément mémoire (22) ayant au moins un état hautement résistif et un état bassement résistif, et un sélecteur (21) agencé en série avec l'élément mémoire, le sélecteur étant électriquement conducteur lorsqu'une tension supérieure à une tension seuil ($V_{th}$) donnée est appliquée au sélecteur. Le dispositif d'écriture comprend au moins un condensateur d'écriture (4) et un dispositif de charge (30a), et est configuré pour charger le condensateur d'écriture puis pour le connecter à la cellule mémoire pour programmer cette cellule.

[Fig. 1]

**Description**

**DOMAINE TECHNIQUE**

Le domaine technique est celui de la micro-électronique, plus particulièrement celui des mémoires résistives.
L'invention concerne notamment un dispositif d'écriture particulier, permettant d'écrire une ou des données dans une telle mémoire résistive.

**ARRIERE-PLAN TECHNOLOGIQUE**

De nouveaux types de mémoires non volatiles, appelées mémoires résistives, ou parfois ReRAM (selon l'acronyme de « Resistive Random Access Memory »), ont été développés ces dernières années. Une mémoire de ce type comprend généralement une matrice de cellules mémoires, parfois appelées « points mémoire », stockant chacune une donnée, par exemple une donnée binaire. La donnée binaire en question est représentée par le niveau de résistance, soit haut, soit bas, de la cellule mémoire considérée. La donnée stockée dans une telle cellule mémoire peut aussi être une donnée pouvant prendre plus de deux valeurs différentes (par exemple quatre valeurs différentes, la donnée regroupant alors deux bits), dans le cas d'une cellule mémoire « multiniveaux ». Dans ce cas, la cellule mémoire présente une résistance égale à l'un de ses niveaux de résistance (dont le nombre est supérieur à deux), niveau qui est associé à la valeur stockée dans la cellule.
Différentes technologies sont envisageables, pour réaliser des cellules mémoire. Il peut par exemple s'agir de cellules mémoire de type filamentaire, comprenant une couche active dans laquelle un filament électriquement conducteur est soit rompu, soit au contraire reformé pour faire varier le niveau de résistance de la cellule mémoire, lors de cycles d'écriture puis de remise à zéro de cette cellule (opérations de SET, lorsque le filament est reformé, et de RESET, lorsque le filament est rompu à nouveau). Une telle cellule mémoire, de type filamentaire, peut par exemple être une cellule de type OxRam (selon l'acronyme anglo-saxon de « Oxide Random Access Memory »), ou de type CB-RAM (selon l'acronyme anglo-saxon de « Conductive Bridge Random Access Memory »). Les cellules mémoire résistives en question peuvent aussi être des cellules de type PCRAM (pour « Phase Change Random Access Memory »), dans lesquelles un changement de phase amorphe-cristallin s'accompagne d'un changement de résistance de la cellule.
Quoiqu'il en soit, pour écrire une donnée à stocker dans l'une des cellules de la matrice, on peut appliquer une tension électrique ou imposer un courant électrique donné à cette cellule, pendant une certaine durée, pour la faire passer de son état hautement résistif à son état bassement résistif, ou inversement.
Mais lors d'une telle opération d'écriture, il faut parfois attendre un certain temps entre l'instant où l'on commence à appliquer la tension d'écriture, et le moment où la cellule mémoire change d'état résistif. Or, le délai correspondant est en partie imprévisible, susceptible de varier d'une cellule à l'autre, et d'une écriture à l'autre : dans certains cas, le basculement peut avoir lieu presque instantanément, au bout d'une ou de quelques nanosecondes seulement, tandis que dans d'autre cas, le basculement peut ne se produire qu'une trentaine ou quarantaine de nanosecondes après l'application de la tension d'écriture. Ce phénomène est parfois appelé « incubation ».
Pour pouvoir écrire convenablement la cellule mémoire considérée, la tension d'écriture doit alors être appliquée sous la forme d'une impulsion en forme de créneau, de durée relativement importante (plus longue que la valeur maximale attendue pour le délai d'incubation). Dans le cas d'un SET, c'est-à-dire dans un cas où on amène la cellule mémoire dans son état bassement résistif, l'instant à partir duquel la cellule devient assez fortement conductrice peut être situé soit au début de cette impulsion, soit plutôt à la fin de celle-ci. Lorsque la cellule mémoire bascule dans son état bassement résistif au début de l'impulsion d'écriture, un courant électrique notable traverse la cellule mémoire pendant une durée importante (i.e.: pendant presque toute la durée de l'impulsion d'écriture). Cela entraine une consommation électrique importante, et peut aussi causer une forme d'altération ou des tensions mécaniques à petite échelle (un « stress ») au sein de la cellule mémoire.
Pour éviter cette surconsommation, et cette possible altération, une solution consiste à un circuit actif de détection et d'arrêt d'écriture (parfois appelé « write termination » en anglais), qui détecte le passage d'un état hautement résistif à un état bassement résistif, pour la cellule à écrire, et qui stoppe l'impulsion d'écriture dès que ce passage a été détecté. Mais cette solution conduit à un dispositif relativement complexe.
Il existe donc un besoin d'un solution simple, fiable, et si possible peu encombrante permettant d'éviter la surconsommation électrique (et la possible altération des cellules mémoire) lors des opérations d'écriture.

**RESUME**

Dans ce contexte, on propose une mémoire comprenant au moins une cellule mémoire résistive, et un dispositif d'écriture pour programmer ladite cellule,

- la cellule mémoire comprenant :

  - un élément mémoire ayant au moins un état hautement résistif et un état bassement résistif, et

  - un sélecteur agencé en série avec l'élément mémoire, le sélecteur étant électriquement conducteur lorsqu'une tension supérieure à une tension seuil donnée est appliquée au sélecteur et à condition qu'un courant traversant le sélecteur soit supérieur à un courant de maintien donné,

- le dispositif d'écriture comprenant au moins un condensateur d'écriture et un dispositif de charge, et étant configuré pour :

  - a) charger le condensateur d'écriture avec le dispositif de charge jusqu'à une tension initiale d'écriture donnée, le condensateur d'écriture étant déconnecté de ladite cellule mémoire pendant la charge du condensateur, puis pour

  - b) connecter le condensateur d'écriture ainsi chargé, à la cellule mémoire, pour programmer ladite cellule.

Comme la tension appliquée à la cellule mémoire pour l'écrire (i.e.: pour la programmer) est appliquée en la connectant au condensateur, l'énergie consommée lors de l'écriture est intrinsèquement limitée (par l'énergie stockée initialement dans le condensateur, lors de l'étape a) de charge). Le passage du courant électrique dans la cellule mémoire, lors de l'opération d'écriture, entraine naturellement (et en quelque sorte, automatiquement) une décroissance de la tension appliquée à la cellule mémoire, du fait de la décharge du condensateur d'écriture dans la cellule mémoire, évitant ainsi une surconsommation électrique, et cela même si l'instant de basculement de l'état hautement résistif à l'état bassement résistif (ou inversement) est en partie imprévisible.

L'utilisation d'un tel sélecteur, bipolaire, à seuil (en pratique de type « backend », parfois appelé aussi co-intégrable), en série avec l'élément mémoire, permet une fabrication commode de la mémoire, ainsi qu'une compacité meilleure qu'en employant un transistor de sélection, à la place du sélecteur en question. Un sélecteur « back-end » (« Back-End-Of-Line », ou BEOL) est typiquement réalisé dans des niveaux supérieurs à 1 situés au-dessus d'un substrat (par exemple un substrat en Silicium), contrairement aux composants "Front-End-Of-Line" (FEOL) qui se fabriquent à la surface du substrat (diodes et transistors CMOS par exemple), notamment au niveau 1. Un tel sélecteur peut être formé de couches déposées sur ou sous une couche mémoire, et gravées en bloc en même temps que la couche mémoire (ce qui permet un auto-alignement du sélecteur et de l'élément mémoire), d'où l'appellation co-intégrable (puisqu'ils sont intégrés dans le même niveau, en termes de technologie de fabrication).

Par ailleurs, dans cette mémoire, la limitation de l'énergie consommée provient à la fois de l'emploi du condensateur d'écriture (comme expliqué plus haut), mais aussi de l'emploi de ce sélecteur, qui, sous une forme particulièrement simple, et en combinaison avec ce condensateur, joue en quelque sorte le rôle d'un circuit de détection et d'arrêt d'écriture, du fait du blocage du sélecteur lorsque le courant qui le traverse devient inférieur au courant de maintien du sélecteur qui a été mentionné ci-dessus. Ce type de sélecteur avec double seuil, est par exemple un sélecteur de type OTS.

Il convient de noter que le sélecteur de type OTS présente deux terminaux et, en conséquence, se commande différemment du sélecteur de type OTS décrit dans le document US2009/0116280A1 qui est, lui, à trois terminaux. Les problématiques d'écriture sont de ce fait différentes.

On notera qu'il n'est du tout immédiat qu'un tel agencement, avec une cellule mémoire à sélecteur à seuil, et avec un condensateur d'écriture, puisse fonctionner convenablement. En effet, la présence de deux seuils de fonctionnement pour le sélecteur (un pour l'ouverture, et l'autre pour la fermeture/maintien), et les exigences liées à l'écriture, pourraient faire craindre : soit que l'on arrive pas faire se décharger suffisamment le condensateur dans l'élément mémoire (le sélecteur se rebloquant trop vite), soit l'apparition de phénomènes oscillatoires indésirables (en effet, du fait de la présence de capacités parasites dans des matrices crossbar 1S1R, il est connu que les sélecteurs à seuil peuvent se bloquer (si les conditions de maintien de l'état conducteur - c'est-à-dire à l'état passant - ne sont pas satisfaites ; en particulier si le courant qui traverse la cellule 1S1R devient inférieur au courant de maintien), puis, sous l'effet d'une recharge des capacités parasites, se débloquer (si la tension aux bornes de la cellule 1S1R redevient supérieure à sa tension de seuil $V_{th,1S1R}$), pour se rebloquer à nouveau, et ainsi de suite, entrainant des oscillations particulièrement indésirables). Par ailleurs, on pourrait craindre à première vue que les valeurs de capacité adaptées soient importantes, rendant ainsi le condensateur d'écriture encombrant. Enfin, on pourrait craindre que l'interfaçage d'un condensateur à toute une matrice de cellules mémoires de type crossbar ajoutent des difficultés, liées par exemple à la présence de fuites, de capacités parasites d'ensemble, d'adressage ou de déclenchement de seuil simultané.

Mais, comme expliqué dans la description, une étude plus détaillée montre que l'utilisation d'un tel sélecteur à seuil et d'un condensateur d'écriture sont en fait compatibles (une décharge, à travers le sélecteur, jusqu'à écriture de l'élément mémoire, est possible en pratique), et même, produisent ensemble un effet intéressant de limitation automatique de décharge.

Par ailleurs, les valeurs de capacité à employer s'avèrent suffisamment petites pour ne pas augmenter notablement l'encombrement d'une matrice de mémoires de type crossbar.

L'invention a également pour aspect une mémoire comprenant une matrice de cellules mémoires résistives de même type comportant au moins une cellule mémoire à programmer, un dispositif d'écriture pour programmer la au moins une cellule mémoire à programmer et un dispositif de connexion configuré pour connecter sélectivement la au moins une cellule mémoire à programmer au dispositif d'écriture, ou pour connecter un groupe donné de cellules mémoire de la matrice au dispositif d'écriture,

- la matrice comprenant des pistes électriques de ligne et des pistes électriques de colonne, chaque cellule mémoire étant connectée entre, d'une part, l'une des pistes électriques de ligne et, d'autre part, l'une des pistes électriques de colonne, cette cellule mémoire comprenant :

    - un élément mémoire ayant au moins un état hautement résistif et un état bassement résistif, et

    - un sélecteur agencé en série avec l'élément mémoire, le sélecteur étant électriquement conducteur lorsqu'une tension supérieure à une tension seuil donnée est appliquée au sélecteur, et à condition qu'un courant traversant le sélecteur soit supérieur à un courant de maintien donné,

- le dispositif d'écriture comprenant au moins un condensateur d'écriture et un dispositif de charge, et étant configuré pour :

    - a) charger le condensateur d'écriture avec le dispositif de charge, jusqu'à une tension initiale d'écriture donnée, puis pour

    - b) connecter le condensateur d'écriture ainsi chargé, à la au moins une cellule mémoire à programmer par le dispositif de connexion, pour programmer ladite cellule.

Outre les caractéristiques mentionnées ci-dessus, la mémoire qui vient d'être présentée comprenant au moins une cellule mémoire ou une matrice de cellules mémoires peut présenter une ou plusieurs des caractéristiques optionnelles suivantes, considérées individuellement ou selon toutes les combinaisons techniquement envisageables :

- le condensateur d'écriture a une capacité électrique supérieure ou égale à une capacité électrique $C_{o,1}$ définie par la formule (F1) suivante :

$$E_{SET} = \frac{1}{2}\left(V_{init}^2 - V_{stop}^2\right)C_{o,1} \qquad (F1)$$

- où :

    - Vinit est la tension initiale d'écriture,

    - $V_{stop}$ est une tension de fin d'écriture, égale, ou supérieure à une tension de maintien à l'état passant de la cellule mémoire, et où

    - $E_{SET}$ est une énergie électrique à apporter à l'élément mémoire pour le faire passer de son état hautement résistif à son état bassement résistif ;

- la capacité électrique du condensateur d'écriture est, en outre, supérieure ou égale à une capacité électrique $C_{o,2}$ définie par la formule (F2) suivante :

$$E_{SET} = \frac{1}{2}\left(\left[\frac{C_{o,2}}{C_{o,2} + C_{par}} V_{init}\right]^2 - V_{stop}^2\right)\cdot\left(C_{o,2} + C_{par}\right) \qquad (F2)$$

- où $C_{par}$ est une capacité électrique parasite, présentée par la mémoire entre le condensateur d'écriture et la cellule programmée à l'étape b) ;

- la capacité du condensateur d'écriture est comprise entre une fois et trois fois $C_{o,2}$ ;

- la capacité électrique du condensateur d'écriture est, en outre, supérieure ou égale à une capacité électrique $C_{o,3}$ définie par la formule (F3) suivante :

$$E_{SET} = \frac{1}{2}\left(\left[\frac{C_{o,3}}{C_{o,3} + C_{par}} \, V_{init}\right]^2 - V_{stop}^2\right).\left(C_{o,3} + C_{par}\right).\alpha \qquad (F3)$$

- avec

$$\alpha = \frac{R_{RESET}}{R_{RESET} + R_{sel}} \cdot \frac{R_{leak}}{R_{leak} + R_{RESET} + R_{sel}} \cdot \left(1 - \frac{R_{par}}{R_{par} + (R_{RESET} + R_{sel})//\,R_{leak}}\right)$$

- où :

  - $R_{par}$ est une résistance parasite série, présentée par la mémoire entre le condensateur d'écriture et la cellule programmée à l'étape b),

  - $R_{RESET}$ est une résistance électrique de l'élément mémoire dans son état hautement résistif,

  - $R_{leak}$ est une résistance de fuite de la matrice,

  - $R_{sel}$ est une résistance électrique du sélecteur à l'état passant, et où

  - $(R_{RESET} + R_{sel})//\,R_{leak}$ est la résistance égale à : la résistance $R_{leak}$ connectée en parallèle de la résistance RRESET + $R_{sel}$ ;

- le dispositif de charge comprend :

  - différentes sources de tension, et
  - un multiplexeur ayant : différentes entrées reliées respectivement à ces différentes sources de tension, et une sortie reliée au condensateur d'écriture, pour connecter sélectivement l'une ou l'autre desdites sources au condensateur d'écriture ;

- le dispositif d'écriture comprend :

  - une source électrique,

  - au moins un condensateur d'écriture supplémentaire,

  - un multiplexeur de charge ayant : une entrée reliée électriquement à la source électrique, et au moins deux sorties, reliées respectivement au condensateur d'écriture et au condensateur d'écriture supplémentaire, pour connecter sélectivement la source électrique à l'un ou à l'autre de ces condensateurs d'écriture,

  - un multiplexeur d'écriture ayant : au moins deux entrées, reliées respectivement au condensateur d'écriture et au condensateur d'écriture supplémentaire, et une sortie reliée électriquement à la cellule mémoire, pour connecter sélectivement la cellule mémoire à programmer à l'un ou à l'autre des condensateurs d'écriture ;

- le dispositif d'écriture comprend un module de commande configuré pour piloter le multiplexeur de charge et le multiplexeur d'écriture de sorte que :

- pendant une première phase: le condensateur d'écriture soit déconnecté de la source et connecté à la sortie du multiplexeur d'écriture, tandis que le condensateur d'écriture supplémentaire est connecté à la source et déconnecté de la sortie du multiplexeur d'écriture, et de sorte que

- pendant une deuxième phase, ultérieure : le condensateur d'écriture supplémentaire soit déconnecté de la source et connecté à la sortie du multiplexeur d'écriture, tandis que le condensateur d'écriture est déconnecté de la sortie du multiplexeur d'écriture ;

- le dispositif d'écriture est configuré pour exécuter les étapes a) et b) plusieurs fois successivement de manière à appliquer à ladite cellule mémoire une séquence de plusieurs impulsions d'écriture successives, et le dispositif d'écriture comprend un circuit de détection et arrêt d'écriture, configuré pour :

- détecter un passage de l'élément mémoire, de son état hautement résistif à son état bassement résistif, ou inversement, puis pour

- commander un arrêt de ladite séquence d"impulsions d'écriture dès que le passage de l'élément mémoire, de son état hautement résistif à son état bassement résistif, ou inversement, a été détecté ;

- le dispositif de connexion est configuré pour, à l'étape b), connecter le condensateur d'écriture à plusieurs cellules mémoire de la matrice, connectées électriquement en parallèle les unes avec les autres ;

- le dispositif de connexion est configuré pour, à l'étape b), connecter le condensateur d'écriture à plusieurs cellules mémoire de la matrice connectées électriquement en séries les unes avec les autres, ou pour connecter électriquement le condensateur d'écriture à ladite cellule mémoire, ainsi qu'à une cellule mémoire d'une autre matrice de cellule mémoire, ces deux cellules mémoire étant connectées électriquement en série l'une à la suite de l'autre.

Un autre aspect de l'invention concerne un procédé d'écriture d'une cellule mémoire résistive, au moyen d'un dispositif d'écriture comprenant au moins un condensateur d'écriture et un dispositif de charge, la cellule mémoire comprenant :

- un élément mémoire ayant au moins un état hautement résistif et un état bassement résistif, et

- un sélecteur agencé en série avec l'élément mémoire, le sélecteur étant électriquement conducteur lorsqu'une tension supérieure à une tension seuil donnée est appliquée au sélecteur et à condition qu'un courant traversant le sélecteur soit supérieur à un courant de maintien donné,

- le procédé comprenant les étapes suivantes :

- a) charger le condensateur d'écriture avec le dispositif de charge jusqu'à une tension initiale d'écriture donnée, le condensateur d'écriture étant déconnecté de ladite cellule mémoire pendant la charge du condensateur, puis

- b) connecter le condensateur d'écriture ainsi chargé, à la cellule mémoire, pour programmer ladite cellule.

Les caractéristiques optionnelles, présentées plus haut en termes de dispositif, peuvent aussi s'appliquer au procédé d'écriture qui vient d'être décrit. En particulier, le condensateur d'écriture employé aux étapes a) et b) peut avoir une capacité électrique supérieure ou égale à la capacité électrique $C_{o,1}$ définie par la formule (F1) ci-dessus.

La présente technologie et ses différentes applications seront mieux comprises à la lecture de la description qui suit et à l'examen des figures qui l'accompagnent.

## BREVE DESCRIPTION DES FIGURES

Les figures sont présentées à titre indicatif et nullement limitatif de l'invention.

La figure 1 représente schématiquement une mémoire résistive.

La figure 2 représente schématiquement, en perspective, une portion d'une matrice de cellules mémoires de la mémoire de la figure 1.

La figure 3 représente schématiquement une caractéristique courant-tension d'un exemple de cellule mémoire pouvant équiper la mémoire de la figure 1.

La figure 4 représente schématiquement une caractéristique courant-tension d'un exemple de sélecteur pouvant équiper cette cellule mémoire.

La figure 5 montre notamment l'évolution temporelle de la tension aux bornes d'un condensateur d'écriture de la mémoire, lors d'une opération d'écriture d'un état bassement résistif dans une cellule mémoire de la mémoire.

La figure 6 est un schéma électrique simplifié d'un dispositif d'écriture pouvant équiper la mémoire de la figure 1, à la place du dispositif d'écriture représenté sur la figure 1.

La figure 7 est un schéma électrique simplifié d'un autre dispositif d'écriture pouvant lui aussi équiper la mémoire de la figure 1, à la place du dispositif d'écriture représenté sur la figure 1.

La figure 8 est un schéma électrique simplifié d'encore un autre dispositif d'écriture pouvant lui aussi équiper la mémoire de la figure 1, à la place du dispositif d'écriture représenté sur la figure 1.

La figure 9 représente schématiquement un mode de connexion entre le dispositif d'écriture de la figure 1 et plusieurs cellules mémoire, connectées en parallèle les unes avec les autres.

La figure 10 représente schématiquement un autre mode de connexion entre le dispositif d'écriture de la figure 1 et plusieurs cellules mémoire, connectées en série les unes avec les autres.

## DESCRIPTION DETAILLEE

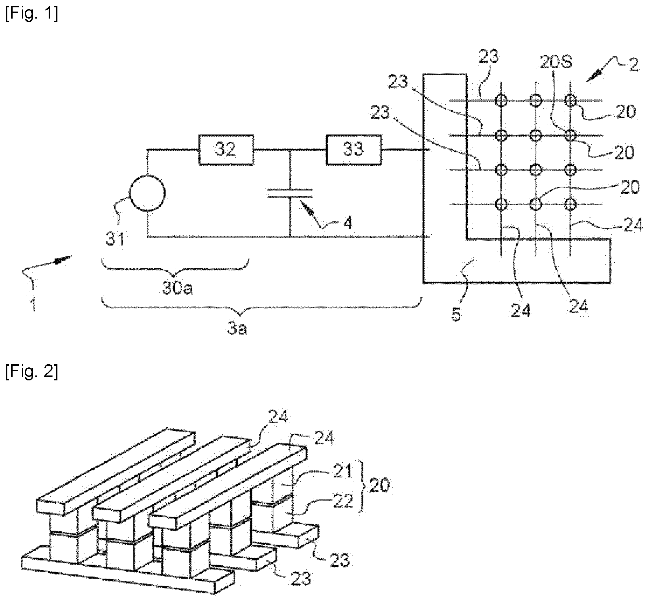

Comme mentionné plus haut, la présente technologie concerne notamment une mémoire, comprenant au moins une, ici plusieurs cellules mémoire résistives, et comprenant un dispositif d'écriture à condensateur pour programmer ces cellules mémoire, c'est-à-dire pour écrire des données dans ces cellules.
Un exemple d'une telle mémoire, 1, est représenté sur la figure 1. Cette mémoire 1 comprend :

-  une matrice 2 de cellules mémoire, 20,

-  le dispositif d'écriture 3a, qui comprend un condensateur d'écriture 4 et un dispositif de charge 30a pour charger ce condensateur, et

-  un dispositif de connexion 5, configuré pour connecter sélectivement le condensateur d'écriture 4 avec l'une des cellules 20 mémoire de la matrice 2, ou avec un groupe donné de cellules 20 mémoire de la matrice.

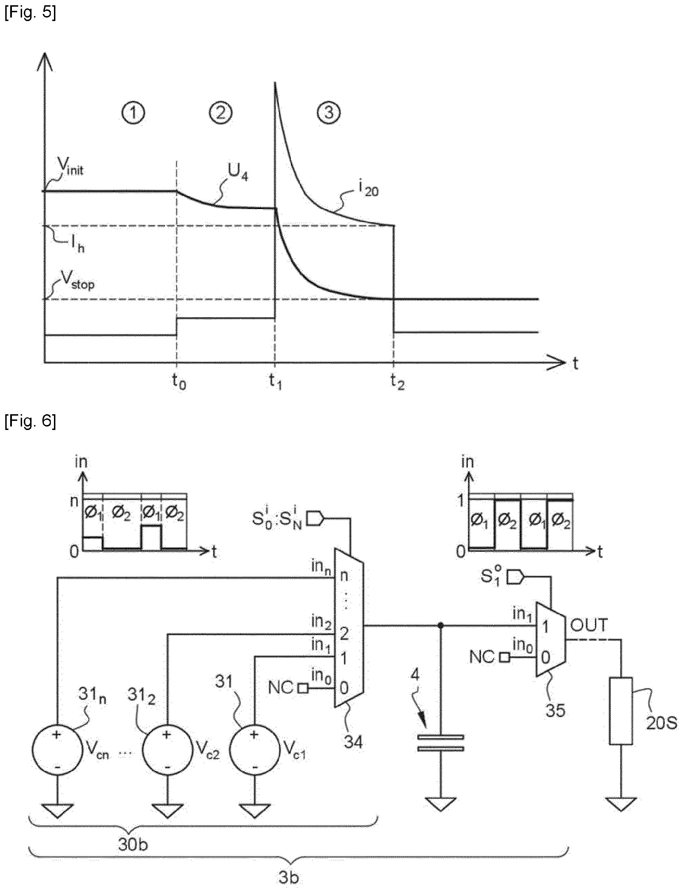

Les figures 6, 7 et 8 représentent schématiquement trois variantes 3b, 3c et 3d du dispositif d'écriture 3a de la figure 1. Chacune de ces variantes peut équiper la mémoire 1 de la figure 1, à la place du dispositif d'écriture 3a.
La mémoire 1 sera décrite tout d'abord de manière générale, dans son ensemble, ainsi que le principe de fonctionnement de son dispositif d'écriture. Le dimensionnement du ou des condensateurs d'écriture sera présenté ensuite plus en détail. Enfin, les variantes du dispositif d'écriture 3b, 3c et 3d, ainsi que des modes de connexion particuliers des cellules mémoire à programmer seront décrits, en référence aux figures 6 à 10.
La matrice 2 comprend n pistes électriques de ligne 23, et m pistes électriques de colonne 24, par exemple métalliques. Les cellules mémoire 20, au nombre de $m \times n$, sont situées aux croisements entre les pistes électriques de ligne et les pistes électriques de colonne. A titre d'exemple, m et n peuvent être égaux à 128. Les cellules mémoire 20 de la matrice sont du même type (elles sont fabriquées ensemble, de la même manière, et présentent donc les mêmes caractéristiques, ou des caractéristiques très proches).
Chaque cellule mémoire 20 est connectée entre, d'une part, l'une des pistes électriques de ligne et, d'autre part, l'une des pistes électriques de colonne. Ainsi, pour appliquer une tension électrique V (par exemple une tension d'écriture) à l'une des cellules mémoire, située au croisement entre l'une des pistes électriques de lignes et l'une des pistes électriques de colonne, on applique cette tension électrique entre cette piste électrique de ligne, et cette piste électrique de colonne.
La matrice 2, et plus généralement la mémoire 1, peut être réalisée par des techniques planaires, sous la forme d'un empilement de plusieurs couches gravées et fonctionnalisées. Comme représenté schématiquement sur la figure 2, les pistes électriques de ligne 23 peuvent alors être situées dans une couche inférieure tandis que les pistes électriques de colonne 24 sont situées dans une couche supérieure (ou inversement), les cellules mémoires 20 (appelées aussi points mémoire) s'étendant alors entre cette couche inférieure et cette couche supérieure. Ce type de matrice est souvent appelée matrice de type « crossbar », dans ce domaine technique.

Chaque cellule mémoire 20 comprend un élément mémoire 22 dont la résistance peut être ajustée électriquement :

- soit à un niveau de résistance bas, lors d'une opération d'écriture généralement appelée « SET »,
- soit à un niveau de résistance haut, lors d'une autre opération d'écriture généralement appelée « RESET » (parfois considéré comme une opération de remise à zéro).

Dans son état bassement résistif, l'élément résistif 22 a une résistance électrique, basse, notée $R_{SET}$, et dans son état hautement résistif, il a une résistance électrique, haute, notée RRESET.

Une donnée peut être écrite et stockée dans chaque cellule mémoire 20, cette donnée étant représentée par le niveau de résistance de l'élément mémoire 22. Ici, les données en question sont des données binaires, et les cellules mémoires sont programmées de manière à placer leurs éléments mémoire 22 respectifs soit dans leur état hautement résistif, soit dans leur état bassement résistif.

Toutefois, en variante, on pourrait exploiter plus de deux niveaux de résistance distincts, pour chaque élément mémoire (éléments « multiniveaux »), de manière à stocker dans chaque cellule une donnée susceptible de prendre plus de deux valeurs différentes. La présente technologie, basée notamment sur un condensateur d'écriture, est présentée ci-dessous dans le cas d'éléments mémoire à deux niveaux mais elle peut s'appliquer aussi à des cellules mémoires multiniveaux telles que mentionnées ci-dessus.

Ici, l'élément mémoire 22 est de type OxRAM. En variante, il pourrait aussi s'agir d'un élément mémoire de type CB-RAM, PCRAM, MRAM (pour « Magnetic RAM » en anglais, où l'on met en œuvre l'aimantation relative entre une couche magnétique de référence et une couche magnétique programmable), ou, plus généralement, de type ReRAM.

Chaque cellule mémoire 20 comprend, en plus de l'élément mémoire 22, un sélecteur 21 agencé en série avec l'élément mémoire 22 (figure 2). D'un point de vue électrique, le sélecteur 21 et l'élément mémoire sont connectés en série, l'un à la suite de l'autre, entre les deux pistes 23, 24 correspondantes. Les cellules mémoire sont du type « 1S1R », ici.

Ces sélecteurs 21 sont des éléments de commutation. Ils permettent de réduire les courants de fuite traversant les cellules ne faisant pas l'objet d'une lecture, ou d'une écriture, à l'instant considéré. Il s'agit de sélecteurs 21 à seuils.

Chaque sélecteur 21 devient électriquement conducteur, c'est-à-dire bascule à l'état passant, lorsque la tension à ses bornes devient supérieure à une tension seuil $V_{th}$. Par ailleurs, les sélecteurs 21 sont du type à seuil de maintien : chaque sélecteur rebascule à l'état bloqué si le courant qui le traverse devient inférieur à un courant de maintien $I_h$.

Les sélecteurs 21 sont des sélecteurs dits « back-end ». Ils sont réalisés par dépôt de couches, qui peuvent être déposées quasiment aux mêmes stades de fabrication que la ou les couches des éléments mémoire 22. Par ailleurs, la ou les couches d'un tel sélecteur peuvent être gravées en même temps que celles de l'élément mémoire correspondant, conjointement (lors d'une même opération de gravure), ce qui facilite la réalisation de la mémoire et permet de réduire au minimum les dimensions de la cellule mémoire 20.

Différentes technologies sont envisageables, pour réaliser ces sélecteurs 21 « backend ». Il peut s'agir par exemple de sélecteurs de type MIT (« metal-insulator transition switch »).

Les sélecteurs 21 peuvent aussi, comme ici, être des sélecteurs de type OTS (pour « Ovonic Threshold Switch », soit commutateur ovonique à seuil). Les sélecteurs de type OTS sont des commutateurs à seuil réalisé à partir de films en alliages de chalcogénures, un tel alliage étant composé d'un élément chalcogène non oxygène (S, Se, Te), en alliage avec des éléments comme Ge, Si, Sb, As, Al, Zn, Ga. Ils peuvent être dopés avec des éléments légers comme B, C, N, O, P (avec des concentrations en dopant qui peuvent être supérieures à 1% atomique).

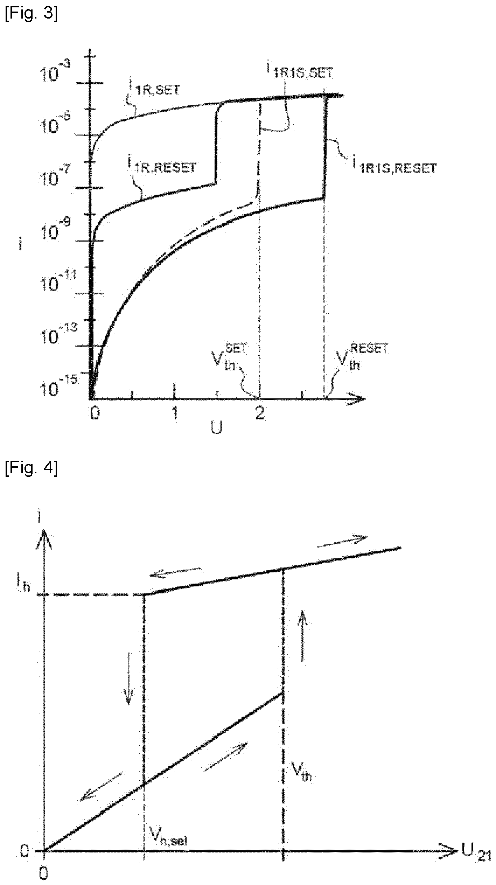

La figure 3 montre des caractéristiques courant-tension pour l'un des éléments mémoire 22 seul, et pour la cellule mémoire 20 complète correspondante (élément mémoire 22 + sélecteur 21).

Sur cette figure, on a représenté le courant électrique i qui traverse l'élément considéré (exprimé en unités arbitraires) en fonction de la tension U appliquée à ses bornes (également en unités arbitraires). Les points de mesure $i_{1R,SET}$ et $i_{1R,RESET}$ correspondent à l'élément mémoire 22 seul, respectivement dans son état bassement résistif et dans son état hautement résistif. Les points de mesure $i_{1R1S,SET}$ et $i_{1R1S,RESET}$ correspondent quant à eux à l'ensemble de la cellule mémoire, lorsque l'élément mémoire 22 est, respectivement, dans son état bassement résistif et dans son état hautement résistif.

Comme on peut le voir sur cette figure, lorsque l'élément mémoire 22 est dans son état bassement résistif (SET) et que le sélecteur 21 n'a pas encore basculé dans son état conducteur, si la tension U appliquée à la cellule mémoire est augmentée progressivement, lorsqu'elle dépasse une tension de seuil de cellule mémoire $V_{th}^{SET}$, le sélecteur bascule à l'état passant, et le courant qui traverse la cellule mémoire augment alors subitement. Avant ce basculement, la résistance de l'élément mémoire 22 (dans son état bassement résistif), $R_{SET}$ (par exemple de l'ordre de quelques kilohms ou éventuellement, de l'ordre de la dizaine ou de quelques dizaines de kilohms, selon la technologie employée), est nettement plus petite que celle du sélecteur (la résistance du sélecteur, juste en dessous de la tension seuil de sélecteur $V_{th}$, est typiquement de l'ordre du mégohm). L'essentiel de la tension U appliquée à la cellule mémoire 20 se retrouve donc aux bornes du sélecteur 21 (la tension U se distribue principalement aux bornes du sélecteur). La tension de seuil de cellule mémoire $V_{th}^{SET}$, est donc très proche de la tension seuil du sélecteur $V_{th}$. La résistance d'ensemble de la cellule mémoire 20 après que le sélecteur ait basculé à l'état passant peut s'exprimer comme RSET + $R_{sel}$ où $R_{sel}$ est une résistance (résistance effective) du sélecteur 21 à l'état passant (par exemple de l'ordre du kilohm).

En revanche, lorsque l'élément mémoire 22 est dans son état hautement résistif (RESET), sa résistance $R_{RESET}$ est plus proche de la résistance du sélecteur 21 juste avant basculement. Le tension U appliquée à la cellule mémoire se répartit alors entre le sélecteur et l'élément mémoire, si bien qu'une tension U à peine supérieure à $V_{th}$ ne suffit plus pour faire basculer le sélecteur dans son état passant (i.e. : dans son état conducteur). En pratique, tant que la tension U est inférieure à un seuil de tension haut $V_{th}^{RESET}$, le sélecteur reste alors bloqué. Au-dessus de ce seuil, non seulement le sélecteur bascule dans son état passant, mais, en plus, l'élément mémoire passe dans son état bassement résistif (alors qu'il était initialement dans son état hautement résistif) ; autrement formulé, un état SET est alors écrit dans la cellule mémoire.

La figure 4 représente schématiquement la caractéristique courant-tension de l'un quelconque des sélecteurs 21. La tension $U_{21}$ appliquée au sélecteur correspond à l'axe des abscisses, tandis que l'axe des ordonnées correspond au courant i qui traverse le sélecteur (en échelle logarithmique). Comme on peut le voir sur cette figure, quand le sélecteur 21 est à l'état passant, si le courant qui le traverse devient inférieur à un courant de maintien $I_h$, alors, le sélecteur rebascule à l'état bloqué. La tension correspondante, aux bornes du sélecteur, juste avant qu'il ne se rebloque, est appelée tension de maintien du sélecteur $V_{h,sel}$.

La tension aux bornes de l'ensemble de la cellule mémoire 20 (sélecteur 21 et élément mémoire 22 compris), lorsque l'élément mémoire 22 est dans son état bassement résistif (SET), et juste avant que le sélecteur 21 ne se re-bloque, est appelée quant à elle tension de maintien $V_{h,1S1R}$. Elle peut s'exprimer comme la somme de la tension de maintien du sélecteur $V_{h,sel}$ et du produit $I_h \times R_{SET}$ : $V_{h,1S1R} = V_{h,sel} + I_h \times R_{SET}$.

Ici, la mémoire 1 comprend également un dispositif de connexion 5, configuré pour connecter sélectivement, c'est-à-dire pour adresser l'une des cellules mémoire 20 de la matrice 2 (par exemple la cellule repérée par la référence 20S, sur la figure 1), au dispositif d'écriture 3a (ou, en variante, 3b, 3c, ou 3d) de la mémoire.

Le dispositif de connexion 5 permet ainsi de sélectionner la cellule à programmer (dans l'exemple de la figure 1, la cellule sélectionnée est la cellule 20S), et de connecter cette cellule (mais pas les autres) au dispositif d'écriture.

Le dispositif de connexion 5 peut aussi être configuré pour connecter un groupe donné de cellules mémoire de la matrice (i.e. : un sous-ensemble donné de cellules mémoire de la matrice) au dispositif d'écriture.

Le dispositif de connexion peut par exemple comprendre plusieurs commutateurs commandables (tels que des transistors), par exemple un pour chaque piste électrique de ligne 23 (en bout de piste), et un pour chaque piste électrique de colonne 24 (en bout de piste).

Le dispositif de connexion 5 peut aussi être configuré pour polariser l'ensemble de la matrice 2 selon une configuration de polarisation électrique donné, lors de l'écriture (ou de la lecture) de la ou des cellules mémoires sélectionnées 20S.

Lors de l'écriture de telle ou telle cellule de la matrice 2, les autres cellules de la matrice (ou, tout au moins, une partie des autres cellules) sont alors elles aussi polarisées (pour ne pas les laisser à un potentiel flottant), mais de manière à leur appliquer une tension qui reste inférieure à une tension d'écriture, au-delà de laquelle ces cellules seraient réécrites. Cette tension de polarisation peut en particulier être inférieure à la tension de seuil $V_{th}$ des sélecteurs. A titre d'exemple, cette configuration de polarisation peut être la configuration généralement appelée « V/2 » dans ce domaine technique. Dans cette configuration, les pistes électriques de ligne et de colonne sont polarisées de sorte que :

- une tension V est appliquée à la cellule sélectionnée 20S,

- tandis qu'une tension de polarisation V/2 est appliquée aux (m+n-2) cellules, autres que la cellule visée 20S, et appartenant à la même ligne et à la même colonne que cette cellule 20S,

- une tension nulle étant appliquée aux autres cellules de la matrice 2.

Quant au dispositif de charge 3a ; 3b ; 3c ; 3d, quelle que soit la variante considérée, il est configuré pour :

- a) charger le condensateur d'écriture 4 avec le dispositif de charge 30a ; 30b ; 30c ; 30d du dispositif d'écriture, jusqu'à une tension initiale d'écriture Vinit donnée (i.e. : jusqu'à ce que la tension aux bornes du condensateur 4 soit égale à cette tension Vinit), le condensateur d'écriture étant déconnecté de la cellule mémoire à programmer pendant la charge du condensateur, puis pour

- b) connecter le condensateur d'écriture 4 ainsi chargé, à la cellule mémoire à programmer, pour programmer cette cellule.

Le dispositif de charge 30a ; 30b ; 30c ; 30d comprend :

- au moins une source électrique, par exemple une source de tension (31, sur la figure 1), pour charger le condensateur d'écriture 4, et

- un premier élément de commutation (32, sur la figure 1), tel qu'un transistor ou un multiplexeur, ayant au moins :

  - un état fermé, dans lequel il connecte la source au condensateur d'écriture 4 (à l'étape a) de charge du condensateur d'écriture), et

  - un état ouvert, dans lequel il déconnecte le condensateur d'écriture 4 de la source.

Le dispositif d'écriture 3a ; 3b ; 3c ; 3d peut aussi comprendre un deuxième élément de commutation (33, sur la figure 1), ayant au moins :

- un état fermé, dans lequel il connecte le condensateur d'écriture 4 et la cellule mémoire à programmer, ici par l'intermédiaire du dispositif de connexion 5, et

- un état ouvert, dans lequel il déconnecte le condensateur d'écriture 4 de cette cellule mémoire.

En pratique, ce deuxième élément de commutation peut soit faire partie du dispositif de connexion 5 (i.e. : être intégré directement au dispositif de commutation 5), soit être distinct de celui-ci.
Le dispositif de charge 30a ; 30b ; 30c ; 30d comprend ici un module de commande (en pratique, un circuit électronique de commande, par exemple un circuit logique intégré programmable), non représenté configuré pour commander les premier et deuxièmes éléments de commutation de manière à :

- connecter la source et le condensateur d'écriture 4 tout en maintenant ce condensateur déconnecté de la cellule à programmer, 20S, pendant l'étape de charge a), puis pour

- connecter le condensateur d'écriture 4 à la cellule à programmer 20S tout en maintenant le condensateur déconnecté de la source, pendant l'étape d'écriture b).

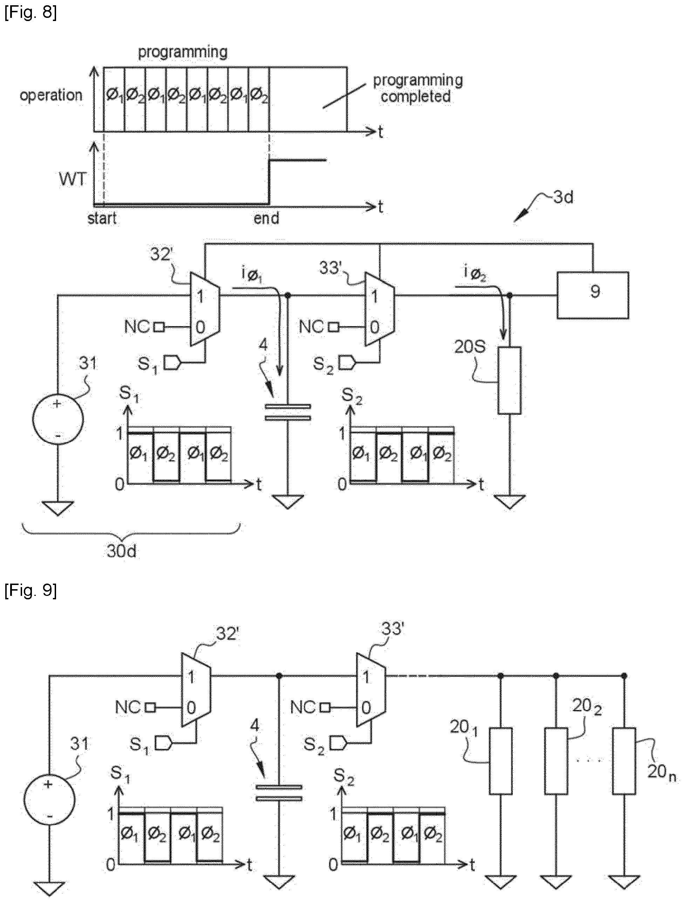

Le dispositif de charge 30a ; 30b ; 30c ; 30d est donc configuré pour, lors de l'étape d'écriture b), déconnecter le condensateur de la source.
Dans l'exemple de la figure 1, le dispositif de charge 30a du dispositif d'écriture 3a comprend la source de tension 31 mentionnée plus haut (cette source de tension délivre par exemple une tension égale à la tension initiale d'écriture Vinit), et le premier élément de commutation, 32.
Une première borne de sortie de la source 31 est connectée à une première borne du condensateur d'écriture 4, par exemple directement (c'est-à-dire par un conducteur électrique, sans composant intermédiaire), tandis que la deuxième borne de sortie de la source est reliée à la deuxième borne du condensateur 4 par l'intermédiaire du premier élément de commutation 32.
Le premier élément de commutation 32 est par exemple un transistor peut aussi s'agir d'un multiplexeur, tel que multiplexeur 32' de la figure 8 ou 9, ayant par exemple deux entrées et une sortie. Dans ce cas, la sortie du multiplexeur est connectée à l'une des deux bornes du condensateur d'écriture, l'une des entrées du multiplexeur est connectée à la deuxième borne de la source, et l'autre entrée du multiplexeur (repérée par le sigle NC sur les figures) est non connectée.
La première borne du condensateur d'écriture 4 est reliée par ailleurs au dispositif de connexion 5 de la matrice 2, par exemple directement, tandis que la deuxième borne de ce condensateur est reliée à ce dispositif de connexion par l'intermédiaire du deuxième élément de commutation 33. Le deuxième élément de commutation peut lui aussi être un transistor, à titre d'exemple, ou un multiplexeur, tel que le multiplexeur 33' de la figure 8, ayant lui aussi une sortie (reliée au dispositif de connexion 5) et au moins deux entrées, l'une reliée à la deuxième borne du condensateur 4, et l'autre non connectée.

La figure 5 montre schématiquement l'évolution, au cours du temps t, de la tension $U_4$ aux bornes d'un condensateur d'écriture 4, lors d'une opération d'écriture d'un état bassement résistif (SET) dans la cellule mémoire 20S de la mémoire 1. L'évolution temporelle du courant électrique $i_{20}$ traversant la cellule mémoire est également représentée.

Comme mentionné plus haut, le condensateur d'écriture 4 est préalablement chargé, à la tension initiale d'écriture Vinit, lors d'une première phase (phase « 1 », sur la figure 5). A la fin de cette première phase, à l'instant $t_0$, le condensateur d'écriture 4 est connecté à la cellule sélectionnée 20S (en commandant à cette fin le deuxième élément de commutation 32 et le dispositif de connexion 5).

Ensuite, la charge électrique contenue initialement dans le condensateur d'écriture 4 commence par se répartir entre ce condensateur et de la capacité parasite $C_{par}$ (capacité parasite de la matrice 2, et des éléments de circuit électrique qui la relie au condensateur d'écriture), au cours d'une deuxième phase (phase « 2 » sur les figures). La tension U aux bornes de la cellule mémoire 20S augmentant alors progressivement en tendant vers une « tension d'équilibre de charges » $V_{eq}$, où $V_{eq}=C/(C+C_{par}).V_{init}$, où C est la capacité électrique du condensateur d'écriture. Lorsque la tension U devient supérieure au seuil de tension haut $V_{th}^{RESET}$ de la cellule mémoire (dans son état hautement résistif), le sélecteur bascule à l'état passant (cet instant est repéré par l'instant $t_1$ sur la figure 5), initiant ainsi une troisième phase, « 3 », de décharge du condensateur d'écriture.

Au cours de cette troisième phase, le condensateur 4 se décharge en partie dans la cellule mémoire 20S, ce qui permet d'apporter à l'élément mémoire 22, une énergie suffisante pour le faire passer de son état hautement résistif à son état bassement résistif. Au cours de cette troisième phase, la tension $U_4$ aux bornes du condensateur d'écriture décroit, ainsi que le courant $i_{20}$ traversant la cellule mémoire. Lorsque le courant $i_{20}$ devient inférieur au courant de maintien $I_h$ (à l'instant t2, sur la figure 5), le sélecteur rebascule dans son état bloqué, ce qui marque la fin de cette troisième phase. La décharge du condensateur d'écriture 4 s'arrête alors (et le courant $i_{20}$ chute notablement). La tension aux bornes du condensateur d'écriture 4, à la fin de cette troisième phase, est appelée tension de fin d'écriture $V_{stop}$. Elle est égale à (où éventuellement légèrement supérieure à) la somme de la tension de maintien $V_{h,1S1R}$ de la cellule mémoire 20, et d'une résistance parasite équivalente de ligne $R_{par}$ multipliée par le courant de maintien $I_h$. La tension de fin d'écriture $V_{stop}$ peut donc aussi s'exprimer comme $V_{h,sel}+R_{par}\times I_h+R_{SET}\times I_h$ où $V_{h,sel}$ est la tension de maintien du sélecteur 21 seul (voir la figure 4), dans un cas où le courant de fuite (total) $I_{leak}$ qui traverse les autres cellules mémoires, non sélectionnées, est négligeable. Si ce n'est pas le cas, la tension de fin d'écriture $V_{stop}$ pourra s'exprimer, plus précisément, comme $V_{h,sel}+R_{par}\times(I_h+I_{leak})R_{SET}\times I_h$.

Comme mentionné dans la partie intitulée « résumé », le fait que le sélecteur se rebloque lorsque le courant devient inférieur au courant de maintien $I_h$ peut paraître problématique à première vue, puisque cela limite l'énergie électrique pouvant être transmise à l'élément mémoire lors de cette décharge (risquant ainsi d'empêcher une écriture convenable de cet élément). Mais en fait, en dimensionnant le condensateur 4 et la source de tension 31 de manière ad-hoc, comme cela est expliqué plus bas, on peut transmettre à l'élément mémoire une énergie suffisante pour réaliser cette écriture avec succès, avant que le sélecteur ne se rebloque. L'effet de reblocage du sélecteur permet alors de limiter l'énergie consommée pour cette écriture (et les éventuels effets de chauffage indésirable de l'élément mémoire), en empêchant une décharge complète du condensateur. En termes de réduction de consommation électrique, cet agencement à condensateur d'écriture et sélecteur à reblocage est donc encore plus performant qu'une solution qui serait basée seulement sur un condensateur d'écriture (solution qui serait pourtant déjà nettement plus performante qu'une écriture réalisée directement à partir d'une source de tension, sans condensateur d'écriture limitant l'énergie totale consommée).

Concernant le dimensionnement du condensateur d'écriture 4, la valeur de sa capacité C est choisie notamment en fonction de l'énergie électrique $E_{SET}$ à apporter à l'élément mémoire 22 pour le faire passer de son état hautement résistif à son état bassement résistif.

Les inventeurs ont en effet constaté que, du moment que le sélecteur est dans son état passant, une opération d'écriture d'un état SET est généralement réalisée avec succès à condition que l'énergie électrique communiquée à la cellule mémoire soit supérieure ou égale à un niveau d'énergie donné, qui est justement l'énergie $E_{SET}$ en question.

L'énergie $E_{SET}$ peut donc être l'énergie minimale, nécessaire en moyenne pour faire passer l'élément mémoire de son état RESET à son état SET (moyenne sur plusieurs éléments mémoire de même type, par exemple, ou moyenne sur plusieurs opérations successives d'écriture d'un état SET, sur le même élément mémoire).

Il peut aussi s'agir de l'énergie au-delà de laquelle la proportion (autrement formulé, la probabilité) de succès de l'opération d'écriture RESET->SET est supérieure à un seuil donné par exemple, supérieure à 90%, ou à 95% (au lieu d'être simplement supérieure à 50%). En particulier, $E_{SET}$ peut être l'énergie au-delà de laquelle le succès de l'opération d'écriture RESET->SET est considéré comme quasiment certain (ce qui correspond par exemple à un seuil de succès de 99%, ou plus ; dans ce cas, la valeur de $E_{SET}$ peut être obtenue par extrapolation, à partir d'une distribution de valeur d'énergie consommée pour plusieurs opérations d'écritures).

L'énergie $E_{SET}$ est l'énergie limite, pour laquelle cette proportion de succès est atteinte, pour un protocole d'écriture donné (en effet, la proportion de succès peut dépendre du protocole d'écriture employé, un tel protocole étant défini par : l'utilisation d'un unique pulse, ou au contraire de plusieurs pulses successifs ; et/ou par la forme, l'amplitude, et/ou la durée du ou des pulses). De préférence, le protocole, correspondant à la valeur de $E_{SET}$ en question, est un protocole ayant des caractéristiques correspondant (par exemple identiques) aux caractéristiques de l'opération d'écriture réalisée avec le présent dispositif d'écriture à condensateur 4.

L'énergie $E_{SET}$ peut être déterminée à partir d'essais réalisés sur un ou des éléments mémoire 22 du type considéré.

Dans une première approche, simplifiée, la capacité C du condensateur d'écriture 4 peut être choisie comme étant supérieure ou égale à la capacité $C_{o,1}$ définie par la formule F1 suivante :

$$E_{SET} = \frac{1}{2}\left(V_{init}^2 - V_{stop}^2\right)C_{o,1} \qquad (F1)$$

La capacité C du condensateur d'écriture 4 peut aussi être choisie en tenant compte de la capacité parasite $C_{par}$ mentionnée plus haut (capacité parasite de la matrice 2, et des éléments de circuit électrique qui la relient au condensateur d'écriture 4). Pour cela, la capacité C peut par exemple être choisie comme étant supérieure ou égale à la capacité $C_{o,2}$ définie par la formule F2 suivante :

$$E_{SET} = \frac{1}{2}\left(\left[\frac{C_{o,2}}{C_{o,2} + C_{par}}\, V_{init}\right]^2 - V_{stop}^2\right) \cdot \left(C_{o,2} + C_{par}\right) \qquad (F2)$$

La valeur minimale à employer pour la capacité C peut être déterminée de manière encore plus précise, en tenant compte de pertes causées par des résistances parasite ou de fuite de la mémoire 1. Lorsqu'on tient compte de ces pertes supplémentaires, un calcul détaillé permet de montrer que la capacité minimale $C_{o,3}$, permettant de communiquer à l'élément mémoire une énergie égale à $E_{SET}$, est donnée par la formule F3 suivante :

$$E_{SET} = \frac{1}{2}\left(\left[\frac{C_{o,3}}{C_{o,3} + C_{par}}\, V_{init}\right]^2 - V_{stop}^2\right) \cdot \left(C_{o,3} + C_{par}\right) \cdot \alpha \qquad (F3)$$

avec

$$\alpha = \frac{R_{RESET}}{R_{RESET} + R_{sel}} \cdot \frac{R_{leak}}{R_{leak} + R_{RESET} + R_{sel}} \cdot \left(1 - \frac{R_{par}}{R_{par} + (R_{RESET} + R_{sel}) // R_{leak}}\right)$$

où :

- $R_{par}$ est la résistance parasite série (résistance de ligne) mentionnée plus haut ; il s'agit de la résistance électrique parasite présentée par la mémoire 1, entre le condensateur d'écriture 4 et la cellule mémoire faisant l'objet de l'opération d'écriture,

- $R_{leak}$ est une résistance de fuite de la matrice (liée notamment aux courants de fuite des autres cellules, non sélectionnées, de la matrice),

- et où $(R_{RESET} + R_{sel}) // R_{leak}$ est une résistance qui est égale à la résistance $R_{leak}$ connectée en parallèle de la résistance $R_{RESET} + R_{sel}$, et qui est donc égale à $1/[1/(R_{leak}) + 1/(R_{RESET} + R_{sel})]$.

La résistance parasite $R_{par}$ peut tenir compte :

- de la résistance électrique des portions de piste de ligne 23 et de piste de colonne 24 entre lesquelles la cellule à écrire 20S est connectée,

- de la résistance électrique des pistes électriques qui relient la matrice 2 au condensateur d'écriture 4,

- et surtout de la résistance à l'état passant (i.e. : à l'état fermé) du ou des composants de connexion commandables (dont le deuxième élément de commutation 33) qui connectent le condensateur d'écriture 4 à la cellule sélectionnée 20S, lors de l'écriture de celle-ci ; en général, cette résistance parasite est supérieure aux deux précédentes.

La résistance parasite $R_{par}$ est par exemple égale à la somme de ces trois contributions.

La résistance de fuite $R_{leak}$ est par exemple égale à la résistance de fuite individuelle d'une cellule mémoire 20 ayant son sélecteur bloqué, divisée par m+n-2 (car m+n-2 telles résistances de fuite individuelles sont connectées en parallèle les unes aux autres). Mais elle peut être différente, selon la configuration de polarisation employée pour polariser la matrice 2 lors de l'écriture de la cellule mémoire considérée 20S (i.e. : selon qu'il s'agisse de la configuration de polarisation « V/2 », ou d'une autre configuration de polarisation).

La capacité parasite $C_{par}$ peut tenir compte :

- d'une capacité électrique effective Cpar,mat de la partie de la matrice 2 formée par ligne et la colonne au croisement desquelles est située la cellule mémoire à programmer 20S ; et

- d'une capacité parasite correspondant aux éléments de circuit électrique (pistes, composants de connexion commandables, ...) qui relient la matrice 2 au condensateur d'écriture 4.

Elle est par exemple égale à la somme de ces deux contributions.

La capacité effective $C_{par,mat}$ de la portion de matrice en question tient compte à la fois des capacités parasites de la piste électrique de ligne 23 et de la piste électrique de colonne 24 considérées, et des capacités électriques des empilements des cellules mémoire non sélectionnées de cette ligne et colonne. Elle peut donc s'exprimer comme m+n-1 fois la capacité parasite individuelle d'une cellule mémoire « non sélectionnée », dans la configuration de polarisation « V/2 » (elle peut toutefois avoir une valeur différente, pour d'autres configurations de polarisation de la matrice). La capacité parasite individuelle d'une cellule mémoire « non sélectionnée » comprend à la fois la capacité de l'empilement formé du sélecteur et de l'élément mémoire (empilement MIM), et la capacité des petites portions de pistes associées à cette cellule mémoire (situées dans le voisinage immédiat de cette cellule ; ces portions étant les éléments de pistes répétés m×n fois pour former l'ensemble des pistes électriques de ligne et de colonne). Cette capacité parasite individuelle est donc la capacité totale d'une « bitcell » de la matrice.

En pratique, les trois estimations $C_{o,1}$, $C_{o,2}$, $C_{o,3}$ de la valeur minimale à donner à la capacité C, s'ordonnent de la manière suivante : $C_{o,1} < C_{o,2} < C_{o,3}$, et c'est l'estimation $C_{o,3}$ qui est la plus précise. En pratique, pour des matrices de petite taille (par exemple de l'ordre de 100x100 cellules ou moins), les valeurs de $C_{o,2}$ et de $C_{o,3}$ peuvent s'avérer proches l'une de l'autre.

La capacité C du condensateur d'écriture 4 peut par exemple être comprise entre une fois $C_{o,2}$, et deux fois $C_{o,2}$ (ou, en alternative, entre une fois $C_{o,2}$, et trois fois $C_{o,2}$). Le fait qu'elle soit supérieure à $C_{o,2}$ permet de transmettre à la cellule mémoire 20s une énergie suffisante pour écrire l'état SET, avec une probabilité de succès élevée. Et le fait qu'elle soit inférieure à deux, ou trois fois $C_{o,2}$ permet de limiter l'énergie électrique consommée lors de cette opération, en restant proche de l'énergie $E_{SET}$ juste nécessaire pour réaliser cette écriture (cela permet aussi de limiter les dimensions du condensateur d'écriture à ce qui est nécessaire pour cette opération d'écriture).

En alternative, La capacité C du condensateur d'écriture 4 pourrait être comprise entre une fois $C_{o,3}$ et deux fois $C_{o,3}$, ou entre une fois $C_{o,3}$ et trois fois $C_{o,3}$.

Pour ce qui est de la tension initiale d'écriture Vinit, elle est par exemple choisie de manière à ce que la tension $V_{eq}=C/(C+C_{par}).V_{init}$, mentionnée plus haut soit supérieure ou égale au seuil de tension haut $V_{th}^{RESET}$ de la cellule mémoire 20S dans son ensemble. Cela permet, aux bornes de la cellule mémoire, d'obtenir une tension suffisante pour réaliser l'opération d'écriture, bien que la charge électrique contenue initialement dans le condensateur d'écriture 4 se répartisse entre ce condensateur et la capacité parasite $C_{par}$ lorsque ce condensateur est connecté à la matrice 2 pour l'opération d'écriture.

Concernant la tension initiale d'écriture Vinit, il peut être intéressant de la choisir relativement élevée (tout en restant compatible avec le type de cellule mémoire et la technologie d'intégration employées), car cela permet alors d'atteindre l'énergie $E_{SET}$ nécessaire à l'écriture même avec un condensateur d'écriture de capacité limitée (autrement formulé, la capacité minimale $C_{o,1}$, $C_{o,2}$ ou encore $C_{o,3}$ est d'autant plus petite que Vinit est grande). Par ailleurs, une tension d'écriture élevée peut conduire à un taux de succès et à une rapidité d'écriture plus élevés.

Un exemple numérique de dimensionnement est présenté ci-dessous.

Dans cet exemple, la matrice 2 est une matrice carrée de 128×128 cellules mémoires 20. Chaque élément mémoire 22 comprend une couche active en oxyde d'hafnium HfO2 de 5 nm d'épaisseur et une électrode active en titane Ti de 5 nm. Chaque sélecteur 21, de type OTS comprend une couche de matériau dit « GSSN » (Ge-Se-Sb-N) d'épaisseur comprise entre 10 et 15 nm. Chaque cellule mémoire 20 a des dimensions latérales de l'ordre de 300 nm. Les valeurs de différentes caractéristiques électriques de cet exemple de mémoire sont données ci-dessous :

- RSET = 5 kilohms ;

- RRESET = 194 kilohms ;

- ESET= 10 pJ ;

- $R_{sel}$ = 1 kilohms ;

- $V_{th}$ = 3 Volts ;

- $I_h$ = 0,1 mA ;

- $R_{par}$ = 5 kilohms ;

- $C_{par}$ =250 pF ;

- $R_{leak}$ = 0,4.$10^6$ Ohms environ.

La tension initiale d'écriture Vinit est choisie égale à 4,6 Volts, dans cet exemple. Quant à la tension de fin d'écriture $V_{stop}$, elle vaut environ 1 Volt.

Pour ces paramètres, la capacité C du condensateur d'écriture 4 peut par exemple être choisie égale à 2 pF (en effet, pour ces paramètres, $C_{o,3}$ vaut 2 pF environ).

Pour cet exemple, des simulations numériques de réponse électrique montre que le cout énergétique totale de l'opération d'écriture de cet état SET est de 15 pJ, et que la durée de la phase 3 décrite plus haut est de 25 ns environ.

A titre de comparaison, pour une écriture réalisée avec une impulsion d'écriture ayant une forme d'échelon (impulsion rectangulaire), avec, typiquement, une amplitude de 3V et un courant de programmation (une fois le sélecteur passant) limité à 200 microampères, la consommation énergétique E de l'opération d'écriture (exprimée en pJ) est de $0,6 \times t_{AS}$(ns), où $t_{AS}$ est la durée pendant laquelle l'impulsion d'écriture continue d'être appliquée, après basculement du sélecteur à l'état passant. En pratique, vue la dispersion des temps de réponse des sélecteurs (i.e. : temps au bout duquel le sélecteur bascule à l'état passant, lorsqu'une tension suffisante lui est appliquée), on est amené à employer des impulsions d'écriture dont la durée est telle que $t_{AS}$ vaut typiquement 100 ns environ, soit une consommation énergétique d'environ 60 pJ, bien supérieure à celle obtenue avec le dispositif d'écriture présenté plus haut.

Par ailleurs, comme illustré par cet exemple, les valeurs de capacité C adaptées pour le condensateur d'écriture s'avèrent comprises typiquement entre 1 et 10 pF, ou éventuellement entre 1 et 100 pF (selon le type de cellules mémoires employées, et selon les dimensions de la matrice). Vu ces valeurs, le condensateur d'écriture peut être intégré de manière commode à la mémoire, en occupant une surface de l'ordre de 0,1×0,1 mm$^2$ ou moins. A titre d'exemple, pour la capacité de 2 pF mentionnée plus haut, une intégration sur une surface de $20\mu m \times 25\mu m$ environ est possible avec les technologies d'intégration de condensateurs disponibles actuellement. En pratique, la surface nécessaire pour réaliser le condensateur d'écriture est comparable, ou même inférieure à la surface occupée par la matrice 2, si bien que le condensateur d'écriture peut par exemple être réalisé sur ou sous la matrice, à l'aplomb de celle-ci.

Le fonctionnement de la mémoire 1 a été présenté en détail ci-dessus dans le cas de l'écriture d'un état SET (bassement résistif). Cette mémoire, et son dispositif d'écriture, peuvent toutefois être employés aussi pour d'écriture d'un état hautement résistif (RESET), c'est-à-dire pour faire passer un élément mémoire 22 de son état bassement résistif à son état hautement résistif. A ce sujet, on notera d'ailleurs que le problème de surconsommation électrique, mentionné en introduction à propos de l'écriture d'un état SET, se pose de manière comparable lors de l'écriture d'un état RESET. En effet, une fois que le sélecteur a basculé à l'état passant, et même si l'élément mémoire a basculé dans son état hautement résistif, un courant électrique non négligeable traverse la cellule mémoire pendant la durée restante de l'impulsion d'écriture. Ce courant est plus faible que dans le cas de l'écriture d'un état SET (puisque l'élément mémoire est dans son état hautement résistif), mais en revanche, l'impulsion d'écriture employée pour un RESET est généralement nettement plus longue (parfois 10 fois plus longue) que pour un SET. L'énergie électrique consommée inutilement, lorsqu'on emploie une impulsion d'écriture de durée fixe, peut donc être aussi élevée pour un RESET que pour un SET. Le dispositif d'écriture particulier présenté plus haut s'applique donc utilement aussi dans le cas d'un RESET.

La figure 6 représente schématiquement une première variante 3b du dispositif d'écriture 3a de la figure 1.

Dans cette variante, le dispositif de charge 30b comprend plusieurs sources de tension $31_1$, $31_2$, ... $31_n$. Ces différentes sources de tensions délivrent des tensions Vc1, Vc2, .. , Vcn différentes. Le dispositif de charge 30b comprend également un multiplexeur 34 ayant :

- différentes entrées $in_1$, $in_2$, ... $in_n$ reliées respectivement à ces différentes sources de tension $31_1$, $31_2$, ... $31_n$,

- et une sortie reliée à la capacité d'écriture 4,

Ce sélecteur comprend également une entrée $in_o$ non connectée. Il permet de pour connecter sélectivement (alternativement) l'une ou l'autre desdites sources à la capacité d'écriture 4, ou de déconnecter le condensateur 4 de ces sources (en le reliant à l'entrée $in_o$ non connectée). Cet agencement permet ainsi d'ajuster sur commande la tension sous laquelle est chargée le condensateur 4, et donc la tension initiale d'écriture $V_{init}$.

Dans ce dispositif d'écriture 3b, le deuxième élément de commutation, qui relie le condensateur d'écriture à la cellule 20S à écriture, est réalisé sous la forme d'un multiplexeur 35 à deux entrées ($in_o$ et $in_1$).

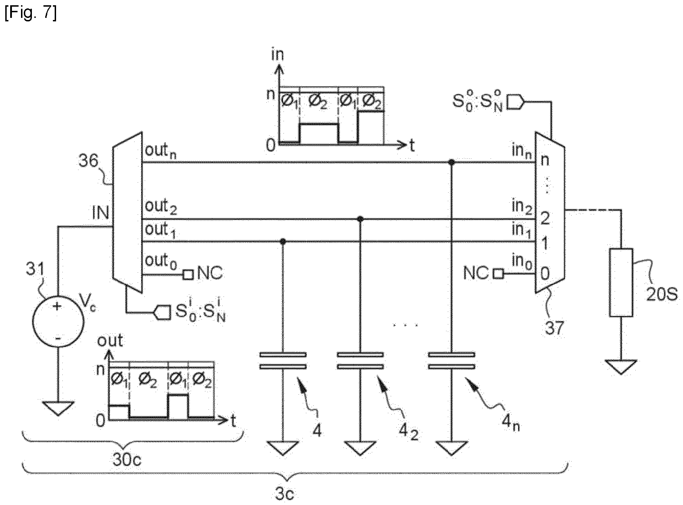

La figure 7 représente schématiquement une deuxième variante 3c du dispositif d'écriture 3a de la figure 1.

Dans cette variante, le dispositif d'écriture 3c comprend :

- une source électrique, ici une source de tension 31,

- le condensateur d'écriture 4, et des condensateurs d'écriture supplémentaires $4_2$,..., $4_n$,

- un multiplexeur de charge 36 ayant une entrée reliée électriquement à la source 31, et plusieurs sorties $out_1$, $out_2$, ... $out_n$, reliées respectivement au condensateurs d'écriture 4 et aux différents condensateurs d'écriture supplémentaires $4_2$, ..., $4_n$, pour connecter sélectivement la source électrique à l'un ou à l'autre des condensateurs d'écriture 4, $4_2$, ..., $4_n$, ou éventuellement à plusieurs de ces condensateurs d'écriture connectés alors en parallèle, et

- un multiplexeur d'écriture 37 ayant plusieurs entrées $in_1$, $ni_2$, ... $in_n$, reliées respectivement au condensateur d'écriture 4 et aux différents condensateur d'écritures supplémentaires $4_2$, ..., $4_n$, et une sortie reliée électriquement à la cellule mémoire 20S à programmer, pour connecter sélectivement cette cellule à l'un ou à l'autre des condensateurs d'écriture, 4, $4_2$, ..., $4_n$, ou éventuellement à plusieurs de ces condensateurs d'écriture connectés alors en parallèle.

La figure 7 montre aussi, sous forme d'encarts :

- les tensions en sortie du multiplexeur de charge 36, au cours du temps t (graphique out(t), en encart), et

- les tensions en entrée du multiplexeur de d'écriture 37, au cours du temps t (graphique in(t), en encart).

Le module de commande du dispositif d'écriture 3c (non représenté), qui produit les signaux de commande $Si_0$:$Si_n$ et $S°_0$:$S°_n$ des multiplexeurs 36 et 37, peut être configuré pour piloter ces multiplexeurs selon deux phases successives ø1 et ø2 répétées plusieurs fois successivement (voir la figure 7).

Dans un premier exemple de la variante 3c, lors de la première phase ø1, les condensateurs 4, $4_2$, ..., $4_n$ sont tous déconnectés de la cellule mémoire 20S. Et un ou plusieurs de ces condensateurs sont connectés à la source 31, pour charger ce ou ces condensateurs. Puis, pendant la deuxième phase ø2, le ou les condensateurs chargés lors de la phase ø1 précédente sont déconnectés de la source 31, et connectés à la cellule 20S pour écrire cette cellule.

Comme on peut le voir, ce dispositif d'écriture 3c permet donc de modifier sur commande la valeur de la capacité électrique employée lors de l'opération d'écriture, soit en sélectionnant l'un ou l'autre des condensateurs 4, $4_2$, ..., $4_n$ (qui peuvent avoir des capacités électriques différentes, soit en connectant, en parallèle, un nombre plus ou moins de ces condensateurs d'écriture.

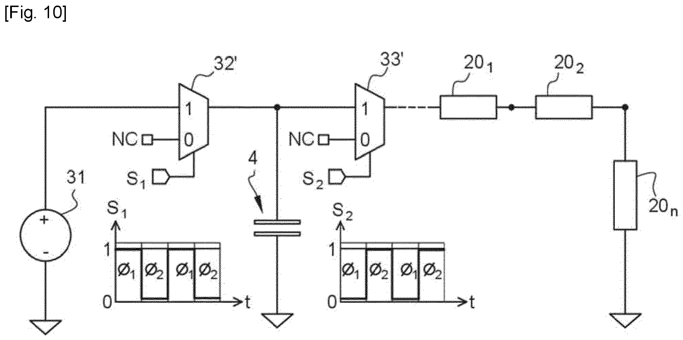

Pouvoir modifier sur commande la valeur de la capacité électrique est intéressant car cela permet par exemple d'écrire simultanément plusieurs cellules mémoire (comme dans l'exemple des figures 9 et 10), en adaptant la valeur de la capacité au nombre de cellules mémoire à écrire.

Par ailleurs, disposer ainsi de plusieurs condensateurs d'écriture permet, si besoin, d'augmenter graduellement l'énergie déchargée dans la cellule à écrire.

Dans un deuxième exemple de la variante 3c, le module de commande est configuré pour commander les multiplexeurs 36 et 37 de manière à :

- décharger l'un des condensateurs d'écriture (par exemple le condensateur 4) dans la cellule mémoire 20S, pendant qu'un autre des condensateurs (par exemple le condensateur $4_2$) est chargé par la source 31, puis

- décharger cet autre condensateur ($4_2$) dans la cellule mémoire, pendant qu'encore une autre condensateur (par exemple $4_n$, ou, à nouveau, 4) est chargé par la source 31, et ainsi de suite.

Cette disposition permet en quelque sorte de disposer d'un condensateur équivalent de grande capacité, sans pour autant être limité par un temps de (pré)charge important, grâce au roulement mis en place entre ces différents condensateurs 4, $4_2$, ..., $4_n$.

Dans le cadre de ce deuxième exemple, le dispositif d'écriture pourrait très bien comprendre seulement deux condensateurs d'écriture, par exemple les condensateurs 4 et $4_2$. Le module de commande serait alors configuré pour commander les multiplexeurs 36 et 37 selon la séquence suivante :

- lors d'une première exécution, préalable, de la phase ø2, le condensateur 4 est chargé par la source 31, puis,

- lors de la phase ø1 suivante, le condensateur d'écriture 4 est déconnecté de la source 31 et connecté à la sortie du multiplexeur d'écriture 37 (pour écrire la cellule mémoire), tandis que le condensateur d'écriture supplémentaire $4_2$ est connecté à la source 31 (pour être chargé) et déconnecté de la sortie du multiplexeur d'écriture 37, puis

- lors de la phase ø2 : le condensateur d'écriture supplémentaire $4_2$ est déconnecté de la source 31 et connecté à la sortie du multiplexeur d'écriture 37, tandis que le condensateur d'écriture 4 est déconnecté de la sortie du multiplexeur d'écriture 37, et connecté à la source 31 (pour être rechargé),

- l'ensemble comprenant la phase ø1, puis la phase ø2 étant ensuite répété, éventuellement plusieurs fois.

Cet arrangement permet de limiter les temps morts liés à la charge du ou des condensateurs d'écriture.

La figure 8 représente schématiquement une troisième variante, 3d, du dispositif d'écriture de la mémoire.

Ce dispositif d'écriture 3d est similaire au dispositif 3a de la figure 1, mais son module de commande est configuré de manière particulière, et il comprend en outre un circuit de détection et arrêt d'écriture 9.

Le circuit de détection et arrêt d'écriture 9 est configuré pour détecter un passage de l'élément mémoire 22 de la cellule sélectionnée 20S, de son état hautement résistif à son état bassement résistif, ou inversement. Lorsque ce passage est détecté, le circuit de détection et arrêt d'écriture 9 émet un signal de détection d'écriture, transmis au module de commande (non représenté).

Quant au module de commande, il est configuré pour commander les multiplexeurs 32' et 33' de manière à exécuter les étapes a) et b) plusieurs fois successivement (autrement formulé, de manière à reproduire les phases ø1, puis ø2 plusieurs fois successivement) de manière à appliquer à la cellule mémoire 20S une séquence de plusieurs impulsions d'écriture successives (technique d'écriture multipluses). Par ailleurs, il est configuré ici pour commander un arrêt de cette séquence d'impulsions d'écriture (en connectant la sortant du multiplexeur 33' à son entrée non connectée, par exemple), dès réception du signal de détection d'écriture.

Comme mentionné plus haut, plusieurs cellules mémoire $20_1$, $20_2$, ..., $20_n$ de la matrice 2 peuvent être écrites simultanément avec le dispositif d'écriture présenté plus haut (qu'il s'agisse de la variante 3a, 3b ou 3c de ce dispositif).

A cette fin, le dispositif de connexion 5 de la mémoire peut être configuré pour, à l'étape b), connecter le condensateur d'écriture 4 (ou les condensateurs d'écriture, si plusieurs condensateurs sont utilisés, en parallèle, ou en alternance) avec plusieurs cellules mémoire $20_1$, $20_2$, ..., $20_n$ de la matrice, connectées électriquement en parallèle les unes avec les autres, comme cela est représenté sur la figure 9. Cette configuration d'écriture est adaptée à l'écriture, dans chacune de ces cellules, d'un état hautement résistif (RESET). En effet, dans cet agencement, lorsque le sélecteur de l'une de ces cellules bascule à l'état passant, son élément mémoire est écrit, dans un état hautement résistif, si bien que cela évite un effondrement de la tension commune appliquée à l'ensemble des cellules sélectionnées $20_1$, $20_2$, ..., $20_n$, et permet de continuer l'opération d'écriture pour les autres cellules, pas encore écrites.

Sur la figure 9, les cellules $20_1$, $20_2$, ..., $20_n$ sont représentées comme étant directement reliées en parallèle les unes aux autres. Mais il s'agit d'une représentation schématique, et en pratique, des éléments de commutation commandable du dispositif de connexion 5 peuvent être présents entre ces différentes cellules.

Le dispositif de connexion 5 de la mémoire peut aussi être configuré pour, à l'étape b), connecter le condensateur d'écriture 4 (ou les condensateurs d'écriture, si plusieurs condensateurs sont utilisés, en parallèle, ou en alternance) avec plusieurs cellules mémoire $20_1$, $20_2$, ..., $20_n$ de la matrice, connectées électriquement en série les unes avec les autres (ou, éventuellement, pour connecter électriquement le condensateur d'écriture 4 à une cellule mémoire de la matrice 2, ainsi qu'à une cellule mémoire d'une autre matrice, ces deux cellules mémoire étant connectées électriquement en série l'une à la suite de l'autre). A la différence de la configuration de la figure 9, cette configuration d'écriture est adaptée à l'écriture, dans chacune de ces cellules, d'un état bassement résistif (SET).

**Revendications**

1. Mémoire (1) comprenant une matrice (2) de cellules (20) mémoires résistives de même type comportant au moins une cellule (20) mémoire à programmer, un dispositif d'écriture (3a ; 3b ; 3c ; 3d) pour programmer la au moins une cellule (20) mémoire à programmer et un dispositif de connexion (5) configuré pour connecter sélectivement la au moins une cellule (20) mémoire à programmer au dispositif d'écriture (3a ; 3b ; 3c ; 3d), ou pour connecter un groupe donné de cellules (20) mémoire de la matrice (2) au dispositif d'écriture (3a ; 3b ; 3c ; 3d),

- la matrice (2) comprenant des pistes électriques de ligne (23) et des pistes électriques de colonne (24), chaque cellule (20) mémoire étant connectée entre, d'une part, l'une des pistes électriques de ligne (23) et, d'autre part, l'une des pistes électriques de colonne (24), cette cellule (20) mémoire comprenant :

  ◦ un élément mémoire (22) ayant au moins un état hautement résistif (RESET) et un état bassement résistif (SET), et
  ◦ un sélecteur (21) agencé en série avec l'élément mémoire, le sélecteur étant électriquement conducteur lorsqu'une tension supérieure à une tension seuil ($V_{th}$) donnée est appliquée au sélecteur, et à condition qu'un courant traversant le sélecteur soit supérieur à un courant de maintien ($I_h$) donné,

- le dispositif d'écriture (3a ; 3b ; 3c ; 3d) comprenant au moins un condensateur d'écriture (4) et un dispositif de charge (30a ; 30b ; 30c ; 30d), et étant configuré pour :

  ◦ a) charger le condensateur d'écriture (4) avec le dispositif de charge (30a ; 30b ; 30c ; 30d), jusqu'à une tension initiale d'écriture (Vinit) donnée, puis pour
  ◦ b) connecter le condensateur d'écriture ainsi chargé, à la au moins une cellule (20) mémoire à programmer par le dispositif de connexion (5), pour programmer ladite cellule (20).

2. Mémoire (1) selon la revendication 1, dans laquelle le condensateur d'écriture (4) a une capacité électrique supérieure ou égale à une capacité électrique $C_{o,1}$ définie par la formule (F1) suivante :

$$E_{SET} = \frac{1}{2}\left(V_{init}^2 - V_{stop}^2\right)C_{o,1} \qquad (F1)$$

- où :

  ◦ Vinit est la tension initiale d'écriture,
  ◦ $V_{stop}$ est une tension de fin d'écriture, égale, ou supérieure à une tension ($V_{h,1S1R}$) de maintien à l'état passant de la cellule mémoire (20), et où
  ◦ $E_{SET}$ est une énergie électrique à apporter à l'élément mémoire (22) pour le faire passer de son état hautement résistif à son état bassement résistif.

3. Mémoire (1) selon la revendication précédente, dans laquelle la capacité électrique du condensateur d'écriture (4) est, en outre, supérieure ou égale à une capacité électrique $C_{o,2}$ définie par la formule (F2) suivante, où $C_{par}$ est une capacité électrique parasite, présentée par la mémoire entre le condensateur d'écriture (4) et la cellule programmée à l'étape b) :

$$E_{SET} = \frac{1}{2}\left(\left[\frac{C_{o,2}}{C_{o,2} + C_{par}}\ V_{init}\right]^2 - V_{stop}^2\right)\cdot\left(C_{o,2} + C_{par}\right) \qquad (F2)$$

4. Mémoire (1) selon la revendication précédente, dans laquelle la capacité du condensateur d'écriture (4) est comprise entre une fois et trois fois $C_{o,2}$.

5. Mémoire (1) selon la revendication 3 ou 4, dans laquelle la capacité électrique du condensateur d'écriture (4) est, en outre, supérieure ou égale à une capacité électrique $C_{o,3}$ définie par la formule (F3) suivante :

$$E_{SET} = \frac{1}{2}\left(\left[\frac{C_{o,3}}{C_{o,3}+C_{par}}\ V_{init}\right]^2 - V_{stop}^2\right).\left(C_{o,3}+C_{par}\right).\alpha \qquad (F3)$$

- avec

$$\alpha = \frac{R_{RESET}}{R_{RESET}+R_{sel}}\cdot\frac{R_{leak}}{R_{leak}+R_{RESET}+R_{sel}}\cdot\left(1-\frac{R_{par}}{R_{par}+(R_{RESET}+R_{sel})//R_{leak}}\right)$$

- où :

  ◦ $R_{par}$ est une résistance parasite série, présentée par la mémoire (2) entre le condensateur d'écriture (4) et la cellule programmée à l'étape b),
  ◦ $R_{RESET}$ est une résistance électrique de l'élément mémoire (22) dans son état hautement résistif,
  ◦ $R_{leak}$ est une résistance de fuite de la matrice (2),
  ◦ $R_{sel}$ est une résistance électrique du sélecteur (21) à l'état passant, et où
  ◦ $(R_{RESET}+R_{sel})//R_{leak}$ est la résistance égale à : la résistance $R_{leak}$ connectée en parallèle de la résistance RRESET + $R_{sel}$.

**6.** Mémoire (1) selon l'une des revendications précédentes, dans laquelle le dispositif de charge (30b) comprend :

  - différentes sources de tension ($31_1$, $31_2$, $31_n$), et
  - un multiplexeur (34) ayant : différentes entrées reliées respectivement à ces différentes sources de tension ($31_1$, $31_2$, $31_n$), et une sortie reliée au condensateur d'écriture (4), pour connecter sélectivement l'une ou l'autre desdites sources au condensateur d'écriture.

**7.** Mémoire (1) selon l'une des revendications 1 à 5, dans laquelle le dispositif d'écriture (3c) comprend :

  - une source (31) électrique,
  - au moins un condensateur d'écriture supplémentaire ($4_2$, $4_n$),
  - un multiplexeur de charge (36) ayant : une entrée reliée électriquement à la source électrique (31), et au moins deux sorties, reliées respectivement au condensateur d'écriture (4) et au condensateur d'écriture supplémentaire ($4_2$, $4_n$), pour connecter sélectivement la source électrique à l'un ou à l'autre de ces condensateurs d'écriture (4, 42, $4_n$),
  - un multiplexeur d'écriture (37) ayant : au moins deux entrées, reliées respectivement au condensateur d'écriture (4) et au condensateur d'écriture supplémentaire ($4_2$, $4_n$), et une sortie reliée électriquement à la cellule mémoire (20), pour connecter sélectivement la cellule mémoire (20) à programmer à l'un ou à l'autre des condensateurs d'écriture (4, $4_2$, 4n).

**8.** Mémoire (1) selon la revendication précédente, dans laquelle le dispositif d'écriture (3c) comprend un module de commande configuré pour piloter le multiplexeur de charge (36) et le multiplexeur d'écriture (37) de sorte que :

  - pendant une première phase (ø1): le condensateur d'écriture (4) soit déconnecté de la source (31) et connecté à la sortie du multiplexeur d'écriture (37), tandis que le condensateur d'écriture supplémentaire ($4_2$, $4_n$) est connecté à la source (31) et déconnecté de la sortie du multiplexeur d'écriture (37), et de sorte que
  - pendant une deuxième phase (ø2), ultérieure : le condensateur d'écriture supplémentaire ($4_2$, $4_n$) soit déconnecté de la source (31) et connecté à la sortie du multiplexeur d'écriture (37), tandis que le condensateur d'écriture (4) est déconnecté de la sortie du multiplexeur d'écriture (37).

**9.** Mémoire (1) selon l'une des revendications 1 à 7, dans laquelle :

  - le dispositif d'écriture (3d) est configuré pour exécuter les étapes a) et b) plusieurs fois successivement de manière à appliquer à ladite cellule (20) mémoire une séquence de plusieurs impulsions d'écriture successives, et dans laquelle

- le dispositif d'écriture comprend un circuit de détection et arrêt d'écriture (9), configuré pour :

∘ détecter un passage de l'élément mémoire (22), de son état hautement résistif à son état bassement résistif, ou inversement, puis pour
∘ commander un arrêt de ladite séquence d''impulsions d'écriture dès que le passage de l'élément mémoire (22), de son état hautement résistif à son état bassement résistif, ou inversement, a été détecté.

**10.** Mémoire (1) selon l'une des revendications 1 à 9, dans laquelle le dispositif de connexion (5) est configuré pour, à l'étape b), connecter le condensateur d'écriture (4) à plusieurs cellules mémoire ($20_1$, $20_2$, $20_n$) de la matrice (2), connectées électriquement en parallèle les unes avec les autres.

**11.** Mémoire (1) selon l'une des revendications 1 à 9, dans laquelle le dispositif de connexion (5) est configuré pour, à l'étape b), connecter le condensateur d'écriture à plusieurs cellules mémoire ($20_1$, $20_2$, $20_n$) de la matrice (2) connectées électriquement en séries les unes avec les autres, ou pour connecter électriquement le condensateur d'écriture (4) à ladite cellule mémoire (20), ainsi qu'à une cellule mémoire d'une autre matrice de cellule mémoire, ces deux cellules mémoire étant connectées électriquement en série l'une à la suite de l'autre.

**12.** Procédé d'écriture d'une cellule (20) mémoire résistive, au moyen d'un dispositif d'écriture (3a ; 3b ; 3c ; 3d) comprenant au moins un condensateur d'écriture (4) et un dispositif de charge (30a ; 30b ; 30c ; 30d), la cellule mémoire (20) comprenant :

- un élément mémoire (22) ayant au moins un état hautement résistif et un état bassement résistif, et
- un sélecteur (21) agencé en série avec l'élément mémoire, le sélecteur étant électriquement conducteur lorsqu'une tension supérieure à une tension seuil ($V_{th}$) donnée est appliquée au sélecteur et à condition qu'un courant traversant le sélecteur soit supérieur à un courant de maintien ($I_h$) donné,
- le procédé comprenant les étapes suivantes :

∘ a) charger le condensateur d'écriture (4) avec le dispositif de charge (30a ; 30b ; 30c ; 30d) jusqu'à une tension initiale d'écriture (Vinit) donnée, le condensateur d'écriture (4) étant déconnecté de ladite cellule mémoire (20) pendant la charge du condensateur, puis
∘ b) connecter le condensateur d'écriture (4) ainsi chargé, à la cellule (20) mémoire, pour programmer ladite cellule.

**13.** Procédé selon la revendication précédente, dans lequel le condensateur d'écriture (4) employé aux étapes a) et b) a une capacité électrique supérieure ou égale à une capacité électrique $C_{o,1}$ définie par la formule (F1) suivante :

$$E_{SET} = \frac{1}{2}\left(V_{init}^2 - V_{stop}^2\right)C_{o,1} \qquad (F1)$$

- où :

∘ Vinit est la tension initiale d'écriture,
∘ $V_{stop}$ est une tension de fin d'écriture, égale, ou supérieure à une tension ($V_{h,1S1R}$) de maintien à l'état passant de la cellule mémoire (20), et où
∘ $E_{SET}$ est une énergie électrique à apporter à l'élément mémoire (22) pour le faire passer de son état hautement résistif à son état bassement résistif.

[Fig. 1]

[Fig. 2]

EP 4 198 985 A1

[Fig. 3]

[Fig. 4]

[Fig. 5]

[Fig. 6]

[Fig. 7]

[Fig. 8]

[Fig. 9]

[Fig. 10]

Europäisches
Patentamt

European
Patent Office

Office européen
des brevets

# RAPPORT DE RECHERCHE EUROPEENNE

Numéro de la demande

EP 22 21 2693

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | US 2017/139628 A1 (YOON JUNG-HYUK [KR] ET AL) 18 mai 2017 (2017-05-18) * alinéas [0050], [0063], [0074] – [0079]; figure 6A * ----- | 1,12 | INV. G11C13/00 G11C11/16 G11C5/14 H10B63/00 |
| X | US 2009/116280 A1 (PARKINSON WARD [US] ET AL) 7 mai 2009 (2009-05-07) * alinéas [0015], [0025] – [0039]; figures 1,3B * ----- | 1,12 | |
| Y | TROTTI P ET AL: "Experimental Set-Up For Novel Energy Efficient Charge-based Resistive RAM (RRAM) Switching", 2020 IEEE 33RD INTERNATIONAL CONFERENCE ON MICROELECTRONIC TEST STRUCTURES (ICMTS), IEEE, 4 mai 2020 (2020-05-04), pages 1-5, XP033777120, DOI: 10.1109/ICMTS48187.2020.9107936 * page 1, colonne de gauche, alinéa 3 – page 5, colonne de gauche, alinéa 1; figure 8 * ----- | 1-13 | |
| Y | ROBAYO D ALFARO ET AL: "Integration of OTS based back-end selector with HfO2 OxRAM for crossbar arrays", 2019 IEEE 11TH INTERNATIONAL MEMORY WORKSHOP (IMW), IEEE, 12 mai 2019 (2019-05-12), pages 1-4, XP033563797, DOI: 10.1109/IMW.2019.8739746 * page 1, colonne de droite, dernier alinéa – page 5, colonne de droite, alinéa 1; figure 10 * ----- -/-- | 1-13 | DOMAINES TECHNIQUES RECHERCHES (IPC) G11C H02N H01L |

Le présent rapport a été établi pour toutes les revendications

| Lieu de la recherche | Date d'achèvement de la recherche | Examinateur |
|---|---|---|
| La Haye | 3 avril 2023 | Colling, Pierre |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
..........................................................
& : membre de la même famille, document correspondant

EPO FORM 1503 03.82 (P04C02)

page 1 de 2

RAPPORT DE RECHERCHE EUROPEENNE

Numéro de la demande

EP 22 21 2693

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| A | US 8 934 280 B1 (KUO HARRY [US] ET AL) 13 janvier 2015 (2015-01-13) * colonne 4, ligne 59 – colonne 9, ligne 62; figure 1 * ----- | 1-13 | |
| A | SEN ZHANG ET AL: "Programming resistive switching memory by a charged capacitor", APPLIED PHYSICS A; MATERIALS SCIENCE & PROCESSING, SPRINGER, BERLIN, DE, vol. 102, no. 4, 5 février 2011 (2011-02-05), pages 1003-1007, XP019890028, ISSN: 1432-0630, DOI: 10.1007/S00339-011-6320-5 * le document en entier * ----- | 1-13 | |

DOMAINES TECHNIQUES RECHERCHES (IPC)

Le présent rapport a été établi pour toutes les revendications

| Lieu de la recherche | Date d'achèvement de la recherche | Examinateur |
|---|---|---|
| La Haye | 3 avril 2023 | Colling, Pierre |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
............................................................
& : membre de la même famille, document correspondant

EPO FORM 1503 03.82 (P04C02)

page 2 de 2

**EP 4 198 985 A1**

## ANNEXE AU RAPPORT DE RECHERCHE EUROPEENNE
## RELATIF A LA DEMANDE DE BREVET EUROPEEN NO.

EP 22 21 2693

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

03-04-2023

| Document brevet cité au rapport de recherche | | Date de publication | Membre(s) de la famille de brevet(s) | | Date de publication |
|---|---|---|---|---|---|
| US 2017139628 | A1 | 18-05-2017 | CN | 106710626 A | 24-05-2017 |
| | | | KR | 20170056242 A | 23-05-2017 |
| | | | US | 2017139628 A1 | 18-05-2017 |
| US 2009116280 | A1 | 07-05-2009 | US | 2009116280 A1 | 07-05-2009 |
| | | | US | 2010020595 A1 | 28-01-2010 |
| US 8934280 | B1 | 13-01-2015 | AUCUN | | |

EPO FORM P0460

Pour tout renseignement concernant cette annexe : voir Journal Officiel de l'Office européen des brevets, No.12/82

**RÉFÉRENCES CITÉES DANS LA DESCRIPTION**

**Documents brevets cités dans la description**

- US 20090116280 A1